# EUROPÄISCHE PATENTSCHRIFT

(11) **EP 4 314 962 B1**
(45) Veröffentlichungstag und Bekanntmachung des Hinweises auf die Patenterteilung: **01.01.2025**
(21) Anmeldenummer: 22728828.9
(22) Anmeldetag: 11.05.2022
(51) Int. Cl.: G05B 19/042, G05B 19/418

(54) **VERFAHREN UND SYSTEM ZUM MANAGEN VON ALARMEN IN MODULAREN PRODUKTIONSANLAGEN**
METHOD AND SYSTEM FOR MANAGING ALARMS IN MODULAR PRODUCTION SYSTEMS
PROCÉDÉ ET SYSTÈME DE GESTION DES ALARMES DANS LES INSTALLATIONS DE PRODUCTION MODULAIRES

(30) Priorität: 28.05.2021 EP 21176513
(43) Veröffentlichungstag der Anmeldung: 07.02.2024
(73) Patentinhaber: Siemens Aktiengesellschaft, 80333 München (DE)
(72) Erfinder: BOTERO HALBLAUB, Andrés, 85614 Kirchseeon (DE); HEINZERLING, Till, 76185 Karlsruhe (DE); MAURMAIER, Mathias, 70839 Gerlingen (DE); SCHENK, Tim, 84034 Landshut (DE); STUTZ, Andreas, 76344 Eggenstein-Leopoldshafen (DE); WINCHERINGER, Christoph, 81369 München (DE)
(74) Vertreter: Siemens Patent Attorneys
(86) Internationale Anmeldenummer: PCT/EP2022/062815
(87) Internationale Veröffentlichungsnummer: WO 2022/248228

(56) Entgegenhaltungen:
- EP-A1- 3 650 970
- MANCA GIANLUCA ET AL: "Detection of Historical Alarm Subsequences Using Alarm Events and a Coactivation Constraint", IEEE ACCESS, IEEE, USA, vol. 9, 22 March 2021 (2021-03-22), pages 46851 - 46873, XP011847045, DOI: 10.1109/ACCESS.2021.3067837
- BLOCH HENRY ET AL: "Orchestration of Services in Modular Process Plants", IECON 2018 - 44TH ANNUAL CONFERENCE OF THE IEEE INDUSTRIAL ELECTRONICS SOCIETY, IEEE, 21 October 2018 (2018-10-21), pages 2935 - 2940, XP033483985, DOI: 10.1109/IECON.2018.8591300

## Beschreibung

Die Erfindung bezieht sich auf ein Verfahren zum Managen von Alarmen in modularen Produktionsanlagen gemäß dem Oberbegriff des Patentanspruches 1 und ein System zum Managen von Alarmen in modularen Produktionsanlagen gemäß dem Oberbegriff des Patentanspruches 6.

Modulare Produktionsanlagen kommen in der Fertigungs- und Verfahrenstechnik zunehmend zum Einsatz, bei dem die Fertigungs- und Verfahrenstechnik und modulare Automation vernetzt werden. Mit dem modularen Aufbau lassen sich Planungszeit und Engineering-Aufwände sowohl von neuen Anlagen als auch beim Umbau bestehender Anlagen deutlich reduzieren. Gerade in Bezug auf die Umbauarbeiten "alter" Anlagensollen spielt rasche Durchführung eine wesentliche Rolle, wenn es darum geht, Stillstandzeiten als auch die Zeit für ein Time-to-Market zu verkürzen. Ein modulares Engineering im Hinblick auf eine modulare Automatisierung war bislang häufig nicht möglich, weil Steuerungen unterschiedlicher Hersteller in einer Produktionsanlage nicht verwendet werden konnten.

Um jedoch ein durchgängiges modulares Engineering und eine modulare Automatisierung zu ermöglichen, wird mit einer VDI/VDE/Namur-Richtlinie 2658 ein Standard definiert, in dem "Process Equipment Assembly <PEA>"-Module, durch den die PEA-Modul-Automatisierung herstellerunabhängig beschrieben werden kann und es können PEA-Module verschiedener Hersteller mit PEA-Steuerungen im Zuge einer Prozess Orchestrierung in einen "Process Orchestration Layer <POL>" integriert werden. Die Integration der PEA-Module erfolgt dabei über einen "Module Type Package <MTP>"-Mechanismus, der vom PEA-Hersteller erzeugt wird und mit dem alle notwendigen Informationen einer "Process Equipment Assembly <PEA>", ein PEA-Bedienbild als Strukturbeschreibung, Dienste als gekapselte Prozessfunktionalitäten und z.B. Alarm- und Diagnose-Aspekte beschrieben werden.

In modularen Produktionsanlagen wird darüber hinaus ein Alarmmanagement immer wichtiger, da sich die Anlagenstruktur häufig ändert und somit ein Erfahrungsaufbau sich schwieriger darstellt. Eine Möglichkeit dies zu verbessern, ist ein Modell zur Beschreibung von Alarmketten, das ebenfalls in dem Standard VDI/VDE/NAMUR 2658 definiert wird. Dieses Modell kann von den PEA-Modulen benutzt werden, um die modulinternen Alarmketten zu beschreiben und die Alarmketten sowohl einer Produktionsanlage-Steuerung als auch einem Betreiber der Produktionsanlage zur Verfügung zu stellen. Dazu ist aber notwendig, dass der PEA-Hersteller erst die Alarmketten ermitteln und die ermittelten Alarmketten dann in das standardisierte Format umsetzen muss.

Eine Möglichkeit dies zu erreichen, besteht darin, dass der PEA-Hersteller durch sein Expertenwissen und durch manuelle Ableitung der Alarmketten diese entsprechend ermittelt und danach manuell die Erfassung gemäß dem Standard vornimmt.

Aus der EP 3 650 970 A1 sind ein Verfahren und eine Vorrichtung zum computergestützten Simulieren eines modularen technischen Systems bekannt, bei dem für ein jeweiliges reales Modul des modularen technischen Systems ein entsprechendes virtuelles Modul generiert wird. Das virtuelle Modul enthält eine Steuerung zum Steuern eines modulspezifischen Prozesses und mindestens ein modulspezifisches Simulationsmodell mit einer zugeordneten Modelltypinformation zur Simulation des modulspezifischen Prozesses. Das virtuelle Modul ist derart eingerichtet, den durch die Steuerung gesteuerten modulspezifischen Prozess mittels des modulspezifischen Simulationsmodells und/oder die Steuerung des realen Moduls nachzubilden und es wird für eine computergestützte Simulation des modularen technischen Systems als Datencontainer bereitgestellt. Das bekannte Verfahren oder System ermöglicht insbesondere eine virtuelle Inbetriebnahme von modularen Prozessanlagen.

Dabei können insbesondere verschiedene Bedienhandlungen, verschiedene Systemspezifikationen und/oder Fehlerszenarien durchgespielt werden.

Aus der IEEE-Publikation von MANCA GIANLUCA ET AL: "Detection of Historical Alarm Subsequences Using Alarm Events and a Coactivation Constraint", IEEE ACCESS, IEEE, USA, Bd. 9, 22. März 2021 (2021-03-22), Seiten 46851-46873, ist es bekannt, die Erkennung historischer Alarmteilsequenzen für Methoden zur Analyse von Alarmfluten zu verwenden. Dabei wird im Vergleich zu bisherigen Methoden mit deren Einschränkungen zur Überwindung dieser ein neuartiger Ansatz vorgestellt, der die Erkennung von Ausreißern in zeitlichen Abständen zwischen Alarmereignissen (Aktivierung und Rückkehr zum Normalzustand) und eine Alarm-Koaktivierungsbedingung nutzt. Dieser basiert auf einem "Tennessee-Eastman-Process" als Vergleichsmaßstab in der Prozessautomatisierung. Hierbei wird die Absicht verfolgt, einen geeigneten Datensatz für die Entwicklung und Bewertung von Alarmmanagementmethoden in komplexen Industrieprozessen unter Verwendung sowohl quantitativer als auch qualitativer Informationen aus verschiedenen Quellen bereitzustellen. Es wird zudem gezeigt, dass die Integration zusätzlicher Informationen für die Gesamtleistung und Robustheit bei der vorgeschlagenen Vorgehensweise von Vorteil ist. So ermöglicht die vorgeschlagene Vorgehensweise eine genauere Erkennung kohärenter historischer abnormaler Situationen, einschließlich Phasen mit aktiven Ursachenstörungen und Normalisierungsphasen, die ihrer Beendigung folgen. Weiterhin hat das vorgeschlagene Vorgehensweise den Vorteil, dass die Detektionsergebnisse weniger von der Alarmanzahl, der Ausbreitungsgeschwindigkeit, der Dauer der Situation und der Zeitdistanz zwischen zwei kausal unabhängigen Situationen im Vergleich zu den Ansätzen bei den bisherigen Methoden beeinflusst werden.

Aus der IEEE-Publikation von BLOCH HENRY ET AL: "Orchestration of Services in Modular Process Plants", IECON 2018 - 44TH ANNUAL CONFERENCE OF THE IEEE INDUSTRIAL ELECTRONICS SOCIETY, IEEE, 21. Oktober 2018 (2018-10-21), Seiten 2935-2940, ist eine Orchestrierung von Services in modularen Prozessanlagen bekannt, bei der die Modularisierung der Prozessanlagen als ein Ansatz angesehen wird, um den steigenden Flexibilitätsanforderungen in der Prozessindustrie Rechnung zu tragen. Dabei werden Module zu einer modularen Prozessanlage zusammengefasst, um eine höhere Flexibilität der Produktion zu erreichen, denn herkömmliche verteilte Steuersysteme unterstützen keine angemessene Flexibilität von Produktionssystemen. Die Module sollten Prozessfunktionen als Services kapseln. Die Services (Dienste) sollten durch eine zustandsbasierte Steuerung aufrufbar und steuerbar sein. Die vorgeschlagene Orchestrierung beinhaltet einen Ansatz zur zustandsbasierten Steuerung der Services (Dienste) nach einem definierten Zustandsmodell, der in zwei Fallstudien und zwei unterschiedliche Implementierungen getestet worden ist. So z.B. in einer Simulationsumgebung basierend auf Matlab Simulink Stateflow und in einer industriellen Implementierung einer Pumpe und einer Steuerung.

Die der Erfindung zugrundeliegende Aufgabe besteht darin, ein Verfahren und ein System zum Managen von Alarmen in modularen Produktionsanlagen anzugeben, mit dem das Alarmmanagement in modularen Produktionsanlagen automatisiert wird.

Diese Aufgabe wird ausgehend von dem im Oberbegriff des Patentanspruchs 1 definierten dem Verfahren durch die im Kennzeichen des Patentanspruches 1 angegebenen Merkmale gelöst.

Darüber hinaus wird die Aufgabe ausgehend von dem im Oberbegriff des Patentanspruchs 6 definierten System durch die im Kennzeichen des Patentanspruches 6 angegebenen Merkmale gelöst.

Die der Erfindung gemäß den unabhängigen Ansprüchen 1 und 6 zugrundeliegenden Idee besteht darin, in Bezug auf eine modulare Produktionsanlage, z.B. eine Industrieautomatisierungsanlage (*vgl. Ansprüche 4 und 9*), bei der für deren modularen, herstellerunabhängigen Aufbau und Betrieb "Process Equipment Assembly <PEA>" PEA -Module (PEA-MD), gesteuert durch eine programmierbare PEA-Steuerung (PEA-ST) und simuliert mit einer projektierbaren PEA-Simulation (PEA-SM), im Zuge einer, insbesondere nach dem Standard VDI/VDE/NAMUR 2658, standardisierten Prozess-Orchestrierung (PO) durch einen "Module Type Package <MTP>"-Mechanismus (MTP-MC) zur PEA-Modulbeschreibung in die Produktionsanlage (PRAL) integriert werden, beim Alarmmanagement
- alle Zustände der modularen Produktionsanlage in Bezug auf ausgelöste Fehler möglicher Fehlerfälle der Produktionsanlage virtuell abzufahren und zu simulieren,
- die dabei auftretenden Simulationsfehler durch kenntlichmachende, z.B. durch Signalgebung, Alarme in Form von Alarmmeldungen begleitend zu protokollieren und ein Alarmmeldungsprotokoll zu erstellen sowie
- aus dem Alarmmeldungsprotokoll Alarmketten zu identifizieren oder Alarmketten zu identifizieren und Alarmzusammenhänge in den Alarmketten zu ermitteln.

Im Detail besteht das Alarmmanagement aus den folgenden sieben Maßnahmen:
(1) virtuellem Auslösen von in Bezug auf potenzielle, bekannte und abrufbare Fehlerfälle der Produktionsanlage korrespondierenden Fehlern, wobei für jeden Fehlerfall der Fehler durch eine entsprechende PEA-Modulanregung bei der PEA-Simulation virtuell ausgelöst wird,
(2) Simulieren eines zu dem jeweils virtuell ausgelösten Fehler gehörenden Simulationsfalls durch die PEA-Simulation, bei dem jeweils mindestens ein Simulationsfehler ermittelt wird,
(3) Erkennen des Simulationsfehlers durch die programmierbare PEA-Steuerung, die daraufhin alle simulationsfehlerbasierten Schalthandlungen entsprechend deren Programmierung ausführt,
(4) Erzeugen von mindestens einer Alarmmeldung zur Alarmkettenverfolgung für jeden erkannten Simulationsfehler durch die PEA-Steuerung,
(5) Erfassen der für alle Fehlerfälle erzeugten Alarmmeldungen und Protokollieren der Alarmmeldungen durch Erstellen eines Alarmmeldungsprotokolls,
(6) Analysieren des Alarmmeldungsprotokolls und auf der Basis dieser Analyse Identifizieren von Alarmketten oder Identifizieren von Alarmketten und Ermitteln von Alarmzusammenhängen in den Alarmketten,
(7) Übergeben von Analyseergebnisse und/oder Ermittlungsergebnisse an den "Module Type Package <MTP>"-Mechanismus zu deren Einbettung in die PEA-Modulbeschreibung.

So können in einem Alarmmanagementsystem die Alarmmanagement-Maßnahmen (1) und (5) in einer Alarmketten-Verfolgungskomponente, die Alarmmanagement-Maßnahme (2) im Zuge der PEA-Simulation auf einer Simulationsplattform, z.B. vom Typ SIMIT, die Alarmmanagement-Maßnahmen (3) und (4) im Zuge der PEA-Steuerung auf einer "Speicherprogrammierbaren Steuerung <SPS>"-Plattform, z.B. vom Typ SIMATIC S7-1500, und die Alarmmanagement-Maßnahmen (6) und (7) in einer Alarmketten-Analysekomponente ausgeführt werden.

Die Alarmketten-Verfolgungskomponente und die Alarmketten-Analysekomponente sind dabei vorzugsweise
- gemäß dem Anspruch 7 im Zuge des Alarmmanagements in der modularen Produktionsanlage Bestandteil eines Programm-Moduls mit Steuerprogrammbefehlen, die in einem nicht-flüchtigen, lesbaren Speicher eines computerimplementiertes Werkzeug, das vorzugsweise ein z.B. als APP ausgebildetes Computer-Programm-Produkt ist und neben dem Speicher einen mit dem Speicher verbundenen Prozessor aufweist, der die Steuerprogrammbefehle des Programm-Moduls ausführt, und/oder
- gemäß dem Anspruch 8 in ein Produktionsanlagen-Testsystem, z.B. einem "Factory Acceptance Tool <FAT>" enthalten.

Die Alarmketten-Verfolgungskomponente, die z.B. als ein Alarmketten-Tracer ausgebildet ist, sorgt für das gezielte Konfigurieren und Durchspielen jedes einzelnen Fehlerszenarios und erfasst und protokolliert durch die von der PEA-Steuerung erzeugten und erhaltenen Alarmmeldungen alle auftretenden Alarme in ihrer zeitlichen Reihenfolge. Nach dem Durchlaufen aller Fehlerszenarien werden das Alarmmeldungsprotokoll mit den protokollierten Alarmmeldungen von der Alarmketten-Verfolgungskomponente bzw. dem Alarmketten-Tracer an die Alarmketten-Analysekomponente, die z.B. als Alarmketten-Analyzer ausgebildet ist, weitergegeben. Diese Alarmketten-Analysekomponente bzw. der Alarmketten-Analyzer analysiert das Alarmmeldungsprotokoll und identifiziert daraus die Alarmkette und übergibt dabei gemäß dem Standard VDI/VDE/NAMUR 2658 die identifizierte Alarmkette an den "Module Type Package <MTP>"-Mechanismus zu Einbettung der Alarmkette in die PEA-Modulbeschreibung.

Das auf diese Weise durchgeführte Alarmmanagement zeichnet sich in vorteilhafter Weise dadurch aus, dass
- die Alarmketten automatisiert erfasst und in richtigem Format abgelegt werden.
- die Alarmketten vollständig erfasst werden, da durch das Simulieren aller Fehlerzustände in der PEA-Simulation mittels eines digitalen Zwillings der Produktionsanlage, der aus einem Modell von Sensoren und Aktoren sowie Prozessen und einer emulierten PEA-Automatisierung besteht, eine Alarmkette ausgelöst wird, die zu einer Alarmkette in der "echten" Produktionsanlage identisch ist.
- sowohl lineare als auch verkettete Alarmketten bestimmt werden können.
- wenn Änderungen in einem "Programmable Logic Controller <PLC>" am PLC-Code vorgenommen werden, so erfordert dies nur ein erneutes Durchführen der vorstehenden automatisierten Alarmmanagement-Maßnahmen und es bedarf keiner manuellen Analysen, was sich durch die vorgenommenen Änderungen geändert hat und welche Auswirkungen diese haben.

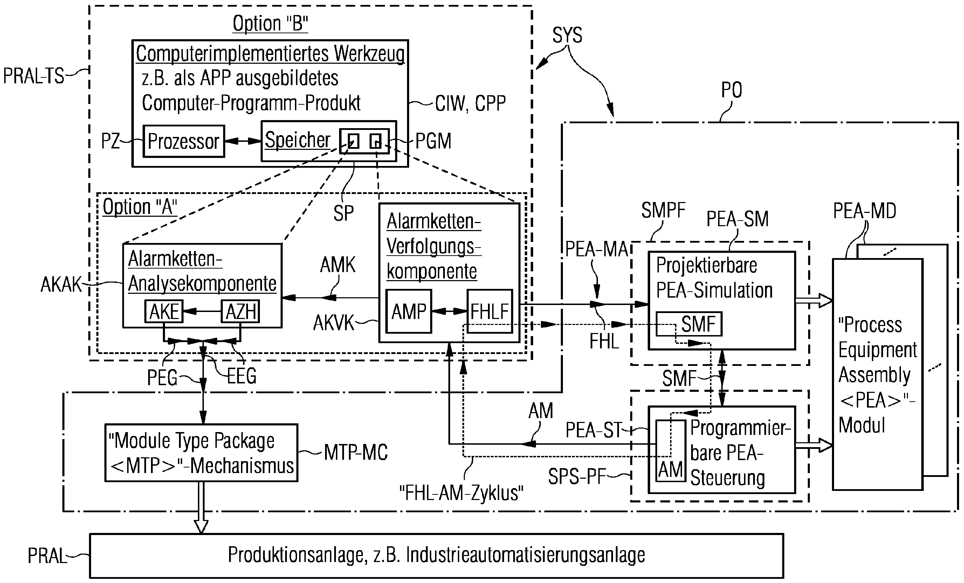

Weitere Vorteile der Erfindung ergeben sich aus der nachfolgenden Beschreibung von zwei Ausführungsbeispielen der Erfindung anhand der einzigen FIGUR erläutert. Diese zeigt: FIGUR ein System zum Managen von Alarmen in einer modularen Produktionsanlage.

Die FIGUR zeigt ein System SYS zum Managen von Alarmen in einer modularen Produktionsanlage PRAL, die z.B. als Industrieautomatisierungsanlage ausgebildet ist. Für das Alarmmanagement weist das System SYS folgende Systemkomponenten auf:
(i) "Process Equipment Assembly <PEA>" PEA -Module PEA-MD für einen modularen, herstellerunabhängigen Aufbau und Betrieb der Produktionsanlage PRAL,
(ii) eine "Speicherprogrammierbare Steuerung <SPS>"-Plattform SPS-PF, z.B. vom Typ SIMATIC S7-1500, auf der eine programmierbare, die <PEA>"-Module PEA-MD steuernde PEA-Steuerung PEA-ST ausführbar ist,
(iii) eine Simulationsplattform SPF, z.B. vom Typ SIMIT, auf der eine projektierbare (z.B. für das Alarmmanagement), die <PEA>"-Module PEA-MD simulierende PEA-Simulation PEA-ST ausführbar ist und die mit der SPS-Plattform SPS-PF funktionellbidirektional verbunden ist,
(iv) einen "Module Type Package <MTP>"-Mechanismus (MTP-MC), durch den die PEA-Module PEA-MD im Zuge einer, vorzugsweise nach dem Standard VDI/VDE/NAMUR 2658, standardisierten Prozess-Orchestrierung PO zur PEA-Modulbeschreibung in die Produktionsanlage PRAL integriert werden und
(v) ein Produktionsanlagen-Testsystem PRAL-TS, z.B. ein "Factory Acceptance Tool <FAT>", in dem
   - gemäß einer Option "A" eine Alarmketten-Verfolgungskomponente AKVK und eine Alarmketten-Analysekomponente AKAK enthalten sind, die für das Alarmmanagement funktional zusammenwirken, oder
   - gemäß einer Option "B" ein computerimplementiertes Werkzeug CIW, das z.B. ein vorzugsweise als APP ausgebildetes Computer-Programm-Produkt CPP ist, mit einem nicht-flüchtigen, lesbaren Speicher SP, in dem prozessorlesbare Steuerprogrammbefehle eines Programm-Moduls PGM gespeichert sind, und einem mit dem Speicher SP verbundenen Prozessor PZ, der die Steuerprogrammbefehle des Programm-Moduls PGM ausführt, wobei das Programm-Modul PGM im Zuge des Alarmmanagements die funktional zusammenwirkenden Alarmketten-Verfolgungskomponente AKVK und Alarmketten-Analysekomponente AKAK enthält.

Gemäß der Option "A" sind die Alarmketten-Verfolgungskomponente AKVK und die Alarmketten-Analysekomponente AKAK als Hardwarekomponenten des Systems SYS (Hardware-Systemkomponenten), während gemäß der Option "B" die Alarmketten-Verfolgungskomponente AKVK und die Alarmketten-Analysekomponente AKAK als Softwarekomponenten des Systems SYS (SoftwareSystemkomponenten) in dem Programm-Modul PGM des als APP ausgebildeten computerimplementierten Werkzeugs CIW respektive des Computer-Programm-Produkts CPP enthalten sind.

In beiden Fällen sind - wie in der FIGUR dargestellt - die entweder als Hardwaresystemkomponenten oder als Softwaresystemkomponenten ausgebildeten Alarmketten-Verfolgungskomponente AKVK und Alarmketten-Analysekomponente AKAK Bestandteil des Produktionsanlagen-Testsystems PRAL-TS. Es ist aber durchaus auch möglich, wenngleich nicht explizit dargestellt, die Hardwaresystemkomponenten oder Softwaresystemkomponenten im Zuge des Alarmmanagements autonom von dem Produktionsanlagen-Testsystem PRAL-TS zu betreiben.

Im Zuge dieses Alarmmanagements und der standardisierten Prozess-Orchestrierung PO wird in der Alarmketten-Verfolgungskomponente AKVK für das Alarmmanagement in Bezug auf alle in Frage kommenden oder potenziellen Fehlerfälle FHLF der Produktionsanlage PRAL mit korrespondierenden Fehlern FHL, die in der Alarmketten-Verfolgungskomponente AKVK gespeichert oder von dieser abrufbar sind, im Rahmen eines "Fehler <FHL>-Alarmmeldung <AM>-Zyklus" für jeden Fehlerfall der entsprechende Fehler durch eine entsprechende PEA-Modulanregung PEA-MA bei der PEA-Simulation PEA-SM auf der Simulationsplattform SPF virtuell ausgelöst.

Die PEA-Simulation PEA-SM auf der Simulationsplattform SPF simuliert daraufhin im Rahmen des "Fehler <FHL>-Alarmmeldung <AM>-Zyklus" einen zu dem jeweils virtuell ausgelösten Fehler gehörenden Simulationsfall und ermittelt dabei jeweils mindestens einen Simulationsfehler SMF ermittelt.

Die programmierbare PEA-Steuerung PEA-ST auf der SPS-Plattform SPS-PF erkennt wieder im Rahmen des "Fehler <FHL>-Alarmmeldung <AM>-Zyklus" über die funktionell-bidirektionale Verbindung mit der PEA-Simulation PEA-SM auf der Simulationsplattform SPF den Simulationsfehler SMF und führt daraufhin alle simulationsfehlerbasierten Schalthandlungen entsprechend deren Programmierung aus. Anschließend erzeugt die programmierbare PEA-Steuerung PEA-ST auf der Basis der ausgeführten simulationsfehlerbasierten Schalthandlungen zur Alarmkettenverfolgung mindestens eine Alarmmeldung AM für jeden erkannten Simulationsfehler SMF.

Abschließend, im Rahmen des "Fehler <FHL>-Alarmmeldung <AM>-Zyklus" erfasst die Alarmketten-Verfolgungskomponente AKVK die die für alle Fehlerfälle FHLF erzeugten Alarmmeldungen AM, protokolliert diese in einem Alarmmeldungsprotokoll AMP und übergibt das Alarmmeldungsprotokoll AMP an die Alarmketten-Analysekomponente AKAK.

In der Alarmketten-Analysekomponente AKAK wird das Alarmmeldungsprotokoll AMP zunächst analysiert und dann werden auf der Basis dieser Analyse Alarmketten AKE identifiziert.

Alternativ dazu ist aber auch möglich, dass in der Alarmketten-Analysekomponente AKAK wieder das Alarmmeldungsprotokoll AMP zunächst analysiert wird und dann werden auf der Basis dieser Analyse wieder Alarmketten AKE identifiziert und zusätzlich Alarmzusammenhänge AZH in den Alarmketten AKE ermittelt.

Als Ergebnisse der Analyse oder der Analyse und der Ermittlung erzeugt die Alarmketten-Analysekomponente AKAK Analyseergebnisse AEG und/oder Ermittlungsergebnisse EEG und übergibt diese an den "Module Type Package <MTP>"-Mechanismus MTP-MC zu deren Einbettung in die PEA-Modulbeschreibung.

## Patentansprüche

1. Verfahren zum Managen von Alarmen in modularen Produktionsanlagen, bei dem
- für einen modularen, herstellerunabhängigen Aufbau und Betrieb einer Produktionsanlage (PRAL) "Process Equipment Assembly <PEA>" PEA -Module (PEA-MD), gesteuert durch eine programmierbare PEA-Steuerung (PEA-ST) und simuliert mit einer projektierbaren PEA-Simulation (PEA-SM), im Zuge einer standardisierten Prozess-Orchestrierung (PO) durch einen "Module Type Package <MTP>"-Mechanismus (MTP-MC) zur PEA-Modulbeschreibung in die Produktionsanlage (PRAL) integriert werden,
- von in Bezug auf potenzielle, gespeicherte oder abrufbare Fehlerfälle (FHLF) der Produktionsanlage (PRAL) korrespondierenden, virtuell ausgelösten Fehlern (FHL) für jeden Fehlerfall der korrespondierende Fehler durch eine entsprechende PEA-Modulanregung (PEA-MA) bei der PEA-Simulation (PEA-SM) virtuell ausgelöst wird,
- ein zu dem jeweils virtuell ausgelösten Fehler gehörender Simulationsfall durch die PEA-Simulation (PEA-SM) simuliert wird und dabei jeweils mindestens ein Simulationsfehler (SMF) ermittelt wird,
- der Simulationsfehler (SMF) durch die programmierbare PEA-Steuerung (PEA-ST) erkannt wird, die daraufhin alle simulationsfehlerbasierten Schalthandlungen entsprechend deren Programmierung ausführt,
**gekennzeichnet durch**
a) Erzeugen von mindestens einer Alarmmeldung (AM) zur Alarmkettenverfolgung für jeden erkannten Simulationsfehler (SMF) durch die PEA-Steuerung (PEA-ST),
b) Erfassen der für alle Fehlerfälle (FHLF) erzeugten Alarmmeldungen (AM) und Protokollieren der Alarmmeldungen (AM) mit Erstellung eines Alarmmeldungsprotokolls (AMP) durch eine Alarmkettenverfolgung (AKVK),
c) Analysieren des Alarmmeldungsprotokolls (AMP) und auf der Basis dieser Analyse Identifizieren von Alarmketten (AKE) oder Identifizieren von Alarmketten (AKE) und Ermitteln von Alarmzusammenhängen (AZH) in den Alarmketten (AKE) durch eine Alarmkettenanalyse (AKAK),
d) Übergeben von Analyseergebnisse (AEG) bei der Identifikation der Alarmketten (AKE) und/oder Ermittlungsergebnisse (EEG) bei der Ermittlung der Alarmzusammenhänge (AZH) in den Alarmketten (AKE) an den "Module Type Package <MTP>"-Mechanismus (MTP-MC) zu deren Einbettung in die PEA-Modulbeschreibung.

2. Verfahren nach Anspruch 1, **dadurch gekennzeichnet, dass**
die virtuelle Fehlerauslösung, die Alarmmeldungserfassung und -protokollierung sowie die Alarmprotokollanalyse mit der Alarmkettenidentifikation oder mit der Alarmkettenidentifikation und der Alarmzusammenhangsermittlung computerimplementiert durchgeführt werden.

3. Verfahren nach Anspruch 1 oder 2, **dadurch gekennzeichnet, dass**
die virtuelle Fehlerauslösung, die Alarmmeldungserfassung und -protokollierung sowie die Alarmprotokollanalyse mit der Alarmkettenidentifikation oder mit der Alarmkettenidentifikation und der Alarmzusammenhangsermittlung von einem Produktionsanlagen-Testsystem (PRAL-TS), z.B. einem "Factory Acceptance Tool <FAT>", durchgeführt werden.

4. Verfahren nach einem der Ansprüche 1 bis 3, **dadurch gekennzeichnet, dass**
die Produktionsanlage (PRAL) eine Industrieautomatisierungsanlage ist.

5. Verfahren nach Anspruch 1, **dadurch gekennzeichnet, dass**
die Prozess-Orchestrierung (PO) gemäß Standard VDI/VDE/NAMUR 2658 standardisiert ist.

6. System (SYS) zum Managen von Alarmen in modularen Produktionsanlagen, mit
- "Process Equipment Assembly <PEA>" PEA -Modulen (PEA-MD) für einen modularen, herstellerunabhängigen Aufbau und Betrieb einer Produktionsanlage (PRAL),
- einer programmierbaren PEA-Steuerung (PEA-ST), die auf einer "Speicherprogrammierbaren Steuerung <SPS>"-Plattform (SPS-PF), z.B. vom Typ SIMATIC S7-1500, ausführbar ist und durch die die PEA-Module (PEA-MD) gesteuert werden,
- einer projektierbaren PEA-Simulation (PEA-SM), die auf einer Simulationsplattform (SPF), z.B. vom Typ SIMIT, ausführbar ist und mit der und die PEA-Module (PEA-MD) simuliert werden, und
- einem "Module Type Package <MTP>"-Mechanismus (MTP-MC), durch den die PEA-Module (PEA-MD) im Zuge einer standardisierten Prozess-Orchestrierung (PO) zur PEA-Modulbeschreibung in die Produktionsanlage (PRAL) integriert werden,
- der PEA-Simulation (PEA-SM), bei der von in Bezug auf potenzielle, gespeicherte oder abrufbare Fehlerfälle (FHLF) der Produktionsanlage (PRAL) korrespondierenden Fehlern (FHL) für jeden Fehlerfall der korrespondierende Fehler durch eine entsprechende PEA-Modulanregung (PEA-MA) virtuell ausgelöst wird,
- der PEA-Simulation (PEA-SM), die einen zu dem jeweils virtuell ausgelösten Fehler gehörenden Simulationsfall simuliert und dabei jeweils mindestens einen Simulationsfehler (SMF) ermittelt,
- der programmierbaren PEA-Steuerung (PEA-ST), die den Simulationsfehler (SMF) erkennt und daraufhin alle simulationsfehlerbasierten Schalthandlungen entsprechend deren Programmierung ausführt,
**gekennzeichnet durch**
**a**) die programmierbare PEA-Steuerung (PEA-ST), die zur Alarmkettenverfolgung mindestens eine Alarmmeldung (AM) für jeden erkannten Simulationsfehler (SMF) erzeugt,
**b**) eine Alarmketten-Verfolgungskomponente (AKVK), die die für alle Fehlerfälle (FHLF) erzeugten Alarmmeldungen (AM) erfasst, in einem Alarmmeldungsprotokoll (AMP) protokolliert und das Alarmmeldungsprotokoll (AMP) an eine Alarmketten-Analysekomponente (AKAK) übergibt,
**c**) die Alarmketten-Analysekomponente (AKAK), die das Alarmmeldungsprotokoll (AMP) analysiert und auf der Basis dieser Analyse Alarmketten (AKE) identifiziert oder Alarmketten (AKE) identifiziert und Alarmzusammenhänge (AZH) in den Alarmketten (AKE) ermittelt,
**d**) die Alarmketten-Analysekomponente (AKAK), die Analyseergebnisse (AEG) bei der Identifikation der Alarmketten (AKE) und/oder Ermittlungsergebnisse (EEG) bei der Ermittlung der Alarmzusammenhänge (AZH) in den Alarmketten (AKE) an den "Module Type Package <MTP>"-Mechanismus (MTP-MC) zu deren Einbettung in die PEA-Modulbeschreibung übergibt.

7. System (SYS) nach Anspruch 6, **gekennzeichnet durch** ein computerimplementiertes Werkzeug (CIW) mit einem nicht-flüchtigen, lesbaren Speicher (SP), in dem prozessorlesbare Steuerprogrammbefehle eines Programm-Moduls (PGM) gespeichert sind, und einem mit dem Speicher (SP) verbundenen Prozessor (PZ), der die Steuerprogrammbefehle des Programm-Moduls (PGM) ausführt, wobei das Programm-Modul (PGM) im Zuge des Alarmmanagements die Alarmketten-Verfolgungskomponente (AKVK) und die Alarmketten-Analysekomponente (AKAK) enthält.

8. System (SYS) nach Anspruch 6 oder 7, **gekennzeichnet durch**
ein Produktionsanlagen-Testsystem (PRAL-TS), z.B. einem "Factory Acceptance Tool <FAT>", in dem die Alarmketten-Verfolgungskomponente (AKVK) und die Alarmketten-Analysekomponente (AKAK) enthalten sind.

9. System (SYS) nach einem der Ansprüche 6 bis 8, **dadurch gekennzeichnet, dass**
die Produktionsanlage (PRAL) eine Industrieautomatisierungsanlage ist.

10. System (SYS) nach Anspruch 6, **dadurch gekennzeichnet, dass**
die Alarmketten-Verfolgungskomponente (AKVK) für jeden Fehlerfall den korrespondierenden Fehler durch die entsprechende PEA-Modulanregung (PEA-MA) virtuell auslöst.

11. System (SYS) nach Anspruch 6, **dadurch gekennzeichnet, dass**
die Prozess-Orchestrierung (PO) gemäß Standard VDI/VDE/NAMUR 2658 standardisiert ist.

12. System (SYS) nach Anspruch 7, **dadurch gekennzeichnet, dass**
das computerimplementierte Werkzeug (CIW) ein z.B. als APP ausgebildetes Computer-Programm-Produkt (CPP) ist.

## Claims

1. Method for managing alarms in modular production installations, in which
- for a modular manufacturer-independent design and operation of a production installation (PRAL), "Process Equipment Assembly <PEA>" PEA modules (PEA-MD) are integrated into the production installation (PRAL) in a manner controlled by a programmable PEA controller (PEA-ST) and simulated using a projectable PEA simulation (PEA-SM) in the course of a standardized process orchestration (PO) by means of a "Module Type Package <MTP>" mechanism (MTP-MC) for the PEA module description,
- of virtually triggered faults (FHL) corresponding to potential, stored or retrievable fault cases (FHLE) of the production installation (PRAL), for each fault case, the corresponding fault is triggered virtually by a corresponding PEA module activation (PEA-MA) in the PEA simulation (PEA-SM),
- a simulation case, which belongs to the fault which is triggered virtually in each case, is simulated by means of the PEA simulation (PEA-SM) and in the process at least one simulation fault (SMF) is determined in each case,
- the simulation fault (SMF) is detected by means of the programmable PEA controller (PEA-ST), which thereupon executes all simulation-fault-based switching actions in accordance with its programming,
**characterized by**
a) generating at least one alarm signal (AM) for alarm chain tracing for each detected simulation fault (SMF) by means of the PEA controller (PEA-ST),
b) detecting the alarm signals (AM) generated for all fault cases (FHLF) and logging the alarm signals (AM) by creating an alarm signal log (AMP) by means of alarm chain tracing (AKVK),
c) analysing the alarm signal log (AMP) and, on the basis of this analysis, identifying alarm chains (AKE) or identifying alarm chains (AKE) and determining alarm correlations (AZH) in the alarm chains (AKE) by means of alarm chain analysis (AKAK),
d) passing analysis results (AEG) of the identification of the alarm chains (AKE) and/or determination results (EEG) of the determination of the alarm correlations (AZH) in the alarm chains (AKE) to the "Module Type Package <MTP>" mechanism (MTP-MC) for the embedding thereof into the PEA module description.

2. Method according to Claim 1, **characterized in that** the virtual fault triggering, the alarm signal detection and logging, and the alarm log analysis with the alarm chain identification or with the alarm chain identification and the alarm correlation determination are carried out in a computer-implemented manner.

3. Method according to Claim 1 or 2, **characterized in that** the virtual fault triggering, the alarm signal detection and logging, and the alarm log analysis with the alarm chain identification or with the alarm chain identification and the alarm correlation determination are carried out by a production installation test system (PRAL-TS), e.g. a "Factory Acceptance Tool <FAT>".

4. Method according to one of Claims 1 to 3, **characterized in that**
the production installation (PRAL) is an industrial automation installation.

5. Method according to Claim 1, **characterized in that**
the process orchestration (PO) is standardized according to the VDI/VDE/NAMUR 2658 standard.

6. System (SYS) for managing alarms in modular production installations, having
- "Process Equipment Assembly <PEA>" modules (PEA-MD) for a modular, manufacturer-independent design and operation of a production installation (PRAL),
- a programmable PEA controller (PEA-ST) which can be executed on a "Programmable Logic Controller <SPS>" platform (SPS-PF), e.g. of SIMATIC S7-1500 type and by means of which the PEA modules (PEA-MD) are controlled,
- a projectable PEA simulation (PEA-SM) which can be executed on a simulation platform (SPF), e.g. of SIMIT type, and using which the PEA modules (PEA-MD) are simulated, and
- a "Module Type Package <MTP>" mechanism (MTP-MC), by means of which the PEA modules (PEA-MD) are integrated into the production installation (PRAL) in the course of a standardized process orchestration (PO) for the PEA module description,
- the PEA simulation (PEA-SM) in which, of faults (FHL) corresponding to potential, stored or retrievable fault cases (FHLF) of the production installation (PRAL), for each fault case, the corresponding fault is triggered virtually by a corresponding PEA module activation (PEA-MA),
- the PEA simulation (PEA-SM) which simulates a simulation case, which belongs to the fault which is triggered virtually in each case, and in the process determines at least one simulation fault (SMF) in each case,
- the programmable PEA controller (PEA-ST) which detects the simulation fault (SMF) and thereupon executes all simulation-fault-based switching actions in accordance with its programming,
**characterized by**
a) the programmable PEA controller (PEA-ST) which generates at least one alarm signal (AM) for alarm chain tracing for each detected simulation fault (SMF),
b) an alarm chain tracing component (AKVK) which detects the alarm signals (AM) generated for all fault cases (FHLF), logs the same in an alarm signal log (AMP) and passes the alarm signal log (AMP) to an alarm chain analysis component (AKAK),
c) the alarm chain analysis component (AKAK) which analyses the alarm signal log (AMP) and, on the basis of this analysis, identifies alarm chains (AKE) or identifies alarm chains (AKE) and determines alarm correlations (AZH) in the alarm chains (AKE),
d) the alarm chain analysis component (AKAK) which passes the analysis results (AEG) of the identification of the alarm chains (AKE) and/or determination results (EEG) of the determination of the alarm correlations (AZH) in the alarm chains (AKE) to the "Module Type Package <MTP>" mechanism (MTP-MC) for the embedding thereof into the PEA module description.

7. System (SYS) according to Claim 6, **characterized by** a computer-implemented tool (CIW) having a non-volatile, readable memory (SP), in which processor-readable control program commands of a program module (PGM) are stored, and a processor (PZ) which is connected to the memory (SP) and which executes the control program commands of the program module (PGM), wherein, in the course of the alarm management, the program module (PGM) contains the alarm chain tracing component (AKVK) and the alarm chain analysis component (AKAK).

8. System (SYS) according to Claim 6 or 7, **characterized by** a production installation test system (PRAL-TS), e.g. a "Factory Acceptance Tool <FAT>", in which the alarm chain tracing component (AKVK) and the alarm chain analysis component (AKAK) are contained.

9. System (SYS) according to one of Claims 6 to 8, **characterized in that**
the production installation (PRAL) is an industrial automation installation.

10. System (SYS) according to Claim 6, **characterized in that** the alarm chain tracing component (AKVK) triggers virtually the corresponding fault for each fault case by means of the corresponding PEA module activation (PEA-MA).

11. System (SYS) according to Claim 6, **characterized in that** the process orchestration (PO) is standardized according to the VDI/VDE/NAMUR 2658 standard.

12. System (SYS) according to Claim 7, **characterized in that** the computer-implemented tool (CIW) is a computer program product (CPP) designed, for example, as an APP.

## Revendications

1. Procédé destiné à la gestion d'alarmes dans des installations de production modulaires, dans lequel
- pour une construction modulaire indépendante du fabricant et une exploitation d'une installation de production (PRAL) des modules d'ensemble d'équipements de traitement, « Process Equipment Assembly <PEA> » (PEA-MD), commandés par le biais d'une commande de PEA programmable (PEA-ST) et simulés avec une simulation de PEA projetable (PEA-SM), dans le cadre d'une orchestration de processus standardisée (PO) par le biais d'un mécanisme d'ensemble de type module, « Module Type Package <MTP> » (MTP-MC) destiné à la description de modules de PEA sont intégrés dans l'installation de production (PRAL),
- par des pannes (FHL) déclenchées virtuellement (RHL) correspondant à l'installation de production (PRAL) par rapport à des cas de panne (FHLF) potentiels enregistrés ou consultables pour chaque cas de panne la panne correspondante est déclenchée virtuellement par le biais d'une stimulation de module de PEA (PEA-MA) lors de la simulation de PEA (PEA-SM),
- un cas de simulation appartenant respectivement à la panne déclenchée virtuellement est simulé par le biais de la simulation de PEA (PEA-SM) et à cet effet respectivement au moins une panne de simulation (SMF) est déterminée,
- la panne de simulation (SMF) est reconnue par le biais de la commande de PEA programmable (PEA-ST) qui réalise ensuite toutes les opérations de commutation basées sur la panne de simulation correspondant à la programmation de celles-ci,
**caractérisé par**
a) la génération d'au moins un signal d'alarme (AM) destiné à un traçage de chaînes d'alarme pour chaque panne de simulation (SMF) reconnue par le biais de la commande de PEA (PEA-ST),
b) l'acquisition des signaux d'alarme (AM) générés pour tous les cas de panne (FHLF) et établissement d'un protocole des signaux d'alarme (AM) avec création d'un protocole de messages d'alarme (AMP) par le biais d'un traçage de chaînes d'alarme (AKVK),
c) l'analyse du protocole de signal d'alarme (AMP) et sur la base de cette analyse l'identification de chaînes d'alarme (AKE) ou l'identification de chaînes d'alarme (AKE) et la détermination de relations d'alarme (AZH) dans les chaînes d'alarme (AKE) par le biais d'une analyse de chaînes d'alarme (AKAK) ;
d) délivrance de résultats d'analyse (AEG) lors de l'identification des chaînes d'alarme (AKE) et/ou de résultats de détermination (EEG) lors de la détermination des relations d'alarme (AZH) dans les chaînes d'alarme (AKE) au niveau du mécanisme d'ensemble de type module « Module Type Package <MTP> » (MTP-MC) jusqu'à l'intégration de celles-ci dans la description de modules de PEA.

2. Procédé selon la revendication 1, **caractérisé en ce que** le déclenchement de panne virtuelle, l'acquisition de signal d'alarme et l'établissement de protocoles d'alarme ainsi que l'analyse de protocoles d'alarme sont exécutés et mis en oeuvre par ordinateur avec l'identification de chaînes d'alarme ou avec l'identification de chaînes d'alarme et la détermination de relations d'alarme.

3. Procédé selon la revendication 1 ou 2, **caractérisé en ce que**
le déclenchement de panne virtuelle, l'acquisition de signal d'alarme et l'établissement de protocoles d'alarme ainsi que l'analyse de protocoles d'alarme sont réalisés avec l'identification de chaînes d'alarme ou avec l'identification de chaînes d'alarme et la détermination de relations d'alarme par un système de test d'installation de production (PRAL-TS), par exemple un outil acceptable en usine, « Factory Acceptable Tool <FAT> ».

4. Procédé selon l'une quelconque des revendications 1 à 3, **caractérisé en ce que**
l'installation de production (PRAL) est une installation d'automatisation industrielle.

5. Procédé selon la revendication 1, **caractérisé en ce que** l'orchestration de processus (PO) est standardisée conformément à la norme VDI/VDE/NAMUR 2658.

6. Système (SYS) destiné à la gestion d'alarmes dans des installations de production modulaires, avec
- des modules d'ensemble d'équipements de traitement, « Process Equipment Assembly <PEA> », (PEA-MD) pour une construction modulaire indépendante du fabricant et une exploitation d'une installation de production (PRAL),
- une commande de PEA programmable (PEA-ST) qui est réalisable sur une plate-forme d' « automate programmable <SPS> » (SPS-PF), par exemple du type SIMATIC S7-1500, et par l'intermédiaire de laquelle les modules de PEA (PEA-MD) sont commandés,
- une simulation de PEA projetable (PEA-SM) qui est réalisable sur une plate-forme de simulation (SPF), par exemple du type SIMIT, et avec laquelle et les modules de PEA (PEA-MD) sont simulés, et
- un mécanisme d'ensemble de type module, « Module Type Package <MTP> » (MTP-MC) par l'intermédiaire duquel les modules de PEA (PEA-MD) sont intégrés dans l'installation de production (PRAL) dans le cadre d'une orchestration de processus standardisée (PO) destinée à la description de modules de PEA,
- la simulation de PEA (PEA-SM) lors de laquelle en ce qui concerne des pannes (FHL) correspondant à des cas de panne (FHLF) potentiels, mémorisés ou consultables (FHLF) de l'installation de production (PRAL) pour chaque cas de panne la panne correspondante est déclenchée virtuellement par le biais d'une stimulation de module de PEA (PEA-MA) correspondante,
- la simulation de PEA (PEA-SM) qui simule un cas de simulation appartenant à la panne respectivement déclenchée virtuellement et à cet effet détermine respectivement au moins une panne de simulation (SMF),
- la commande de PEA programmable (PEA-ST) qui reconnaît la panne de simulation (SMF) et de ce fait réalise toutes les opérations de commutation basées sur la panne de simulation correspondant à la programmation de celles-ci,
**caractérisé par**
a) la commande de PEA programmable (PEA-ST) qui génère au moins un signal d'alarme (AM) pour chaque panne de simulation (SMF) reconnue pour le traçage de chaînes d'alarme,
b) un composant de traçage de chaînes d'alarme (AKVK) qui acquiert les signaux d'alarme (AM) générés pour tous les cas de panne (FHLF) crée un protocole dans un protocole de signaux d'alarme (AMP) et transmet le protocole de signaux d'alarme (AMP) à un composant d'analyse de chaînes d'alarme (AKAK),
c) le composant d'analyse de chaînes d'alarme (AKAK) qui analyse le protocole de signaux d'alarme (AMP) et l'identifie sur la base de cette analyse ou identifie des chaînes d'alarme (AKE) et détermine des relations d'alarme (AZH) dans les chaînes d'alarme (AKE),
d) le composant d'analyse de chaînes d'alarme (AKAK) qui transmet des résultats d'analyse (AEG) lors de l'identification des chaînes d'alarme (AKE) et/ou des résultats de détermination (EEG) lors de la détermination des relations d'alarme (AZH) dans les chaînes d'alarme (AKE) au mécanisme d'ensemble de type module, « Module Type Package <MTP> », (MTP-MC), lors de l'intégration de celles-ci dans la description de modules de PEA.

7. Système (SYS) selon la revendication 6, **caractérisé par** un outil mis en oeuvre par ordinateur (CIW) avec une mémoire lisible non volatile (SP) dans laquelle des instructions de programme de commande lisibles par processeur d'un module de programme (PGM) sont enregistrées, et un processeur (PZ) relié à la mémoire (SP) qui réalise les instructions de programme de commande du module de programme (PGM), dans lequel le module de programme (PGM) contient les composants de traçage de chaînes d'alarme (AKVK) et les composants d'analyse de chaînes d'alarme (AKAK) dans le cadre de la gestion d'alarme.

8. Système (SYS) selon la revendication 6 ou 7, **caractérisé par**
un système de test d'installations de production (PRAL-TS), par exemple un outil de réception en usine, « Factory Acceptance Tool <FAT> » dans lequel les composants de traçage de chaînes d'alarme (AKVK) et les composants d'analyse de chaînes d'alarme (AKAK) sont contenus.

9. Système (SYS) selon l'une quelconque des revendications 6 à 8, **caractérisé en ce que**
l'installation de production (PRAL) est une installation d'automatisation industrielle.

10. Système (SYS) selon la revendication 6, **caractérisé en ce que**
le composant de traçage de chaînes d'alarme (AKVK) déclenche virtuellement pour chaque cas de panne la panne correspondante par le biais de la stimulation de module de PEA (PEA-MA) correspondante.

11. Système (SYS) selon la revendication 6, **caractérisé en ce que**
l'orchestration de processus (PO) est standardisée conformément à la norme VDI/VDE/NAMUR 2658.

12. Système (SYS) selon la revendication 7, **caractérisé en ce que**
l'outil mis en oeuvre par ordinateur (CIW) est par exemple un produit de programme informatique (CPP) configuré en tant qu'APP.
